# EUROPEAN PATENT APPLICATION

(11) **EP 4 436 042 A1**
(43) Date of publication of application: **25.09.2024**
(21) Application number: 23163942.8
(22) Date of filing: 24.03.2023
(51) Int. Cl.: H03K 17/10, H03K 17/687, H03K 17/22, H03K 17/30

(54) **SYNCHRONOUS RECTIFIER ARRANGEMENT**

(71) Applicant: Siemens Aktiengesellschaft, 80333 München (DE)
(72) Inventor: Melkonyan, Ashot, 81549 München (DE)
(74) Representative: Siemens Patent Attorneys

(57) **Abstract**

A synchronous rectifier arrangement comprises a cascode circuit of a high-voltage switch and a low-voltage semiconductor switch, wherein the low-voltage switch is controlled by a low-voltage synchronous rectifier gate driver unit.

## Description

The present invention relates to a rectifier arrangement, in particular a synchronous rectifier.

Synchronous rectification is a well-known possibility to reduce a rectifier diode's forward conduction losses by switching a parallel transistor to its ON state synchronously to the diode, shunting the diode with the channel of the parallel connected transistor. This methodology has been mainly used in low voltage and high current applications. Here the forward voltage and current signals can be sensed directly by a controller and forwarded to the low voltage Gate Drive Unit (GDU). Typical commercial synchronous rectifier controllers can sense and drive low voltage, high current MOSFETs only.

High voltage power MOSFETs, particularly those based on Wide Band Gap (WBG) semiconductors, having very low on-state resistances can be used as synchronous rectifiers, even at high voltage levels of 600 V to 1200 V. However, the existing low voltage synchronous rectifier controllers, which are dedicated to driving low voltage switches, cannot be directly used for those applications. Solutions such as galvanically or optically isolated drivers and sensors are expensive and therefore not always practical for industrial applications. Synchronous rectifier methods with high voltage bridge drivers may suffer from lowered sensitivity and accuracy due to very high dynamic voltage range and low CMR immunity. The model-based synchronous rectifiers are typically suited for a specific operating point of a specific converter only and may suffer from light load or no-load operating conditions.

It is an object of the present invention to provide an improved rectifier arrangement, particularly a synchronous rectifier arrangement for high-voltage applications using a low-voltage gate drive unit.

A synchronous rectifier arrangement in accordance with the invention comprises a first, depletion-mode, semiconductor switch with first and second load terminals and a first control terminal. It further comprises a second, enhancement mode, low-voltage semiconductor switch with third and fourth load terminals and a second control terminal. The second and third load terminals are electrically connected, the two semiconductor switches thus forming a series connection.

A control circuit is connected to the second control terminal and arranged to turn the second semiconductor switch on and off by applying a signal to the second control terminal.

The first semiconductor switch has a higher maximum reverse voltage than the second semiconductor switch and the control circuit is a low-voltage synchronous rectifier control circuit.

For the semiconductor switches, turning on means bringing them to a conducting state that allows current to flow between the load terminals. Turning off means bringing them to a non-conducting mode that prevents current flow between the load terminals.

The synchronous rectifier arrangement advantageously uses a cascode-like arrangement of two switches. The second switch is a low-voltage switch such as a 30 V Si MOSFET. A low-voltage gate drive unit is used to control that low-voltage switch. The cascode arrangement in turn provides protection of the low-voltage second semiconductor switch by the first switch from voltages that are possibly higher than the reverse voltage of the second switch. The first switch in turn is turned on and off indirectly by the cascode arrangement. Active controlling of the low-voltage second semiconductor switch provides a synchronous rectifier operation mode for input voltages that may be as high as the first semiconductor's reverse voltage.

Further features that may be added alone or together in exemplary embodiments of the invention include:
The reverse voltage of the first switch may be at least 400 V, particularly at least 1200 V. The first semiconductor switch may in other words be a high-voltage switch. With a high-voltage switch as the first semiconductor switch the second semiconductor switch can be protected from the same high voltages and can thus itself remain a low-voltage switch. The reverse voltage of the second switch may thus be at most 100 V and in some embodiments at most 50 V.

The synchronous rectifier arrangement may comprise a diode arranged in parallel to the second semiconductor switch. The diode is preferably oriented to block a forward polarity voltage across it and the second semiconductor switch. This enables the arrangement to operate as a passive rectifier wherein the first semiconductor switch protects the diode from high input voltages.

In an advantageous embodiment the diode is a Schottky diode. Silicon (Si) Schottky diodes have a low forward voltage drop and therefore cause low conducting losses, but they are not available as intrinsic high-voltage devices. The first semiconductor switch protects the Schottky diode from high input voltages. Together with the high voltage first semiconductor switch the Schottky diode may then act as a high-voltage Schottky diode equivalent.

A first control circuit control terminal may be connected across a first resistor to the first control terminal of the first semiconductor switch. This allows controlling the state of the first semiconductor switch directly and thus enables the synchronous rectifier arrangement to operate as a high-voltage normally-off FET switch.

A second control circuit control terminal may be connected across a second resistor to the second control terminal of the second semiconductor switch. This allows controlling the state of the second semiconductor switch directly and thus enables the synchronous rectifier arrangement to operate as an active high-voltage rectifier. To enable such a first operating mode, the control circuit may be arranged to, during the first operating mode, obtain a signal indicative of the voltage across the second semiconductor switch and may further be arranged to turn on the second semiconductor switch when the signal indicates a reverse polarity voltage.

Furthermore, the control circuit may be arranged to, during a second operating mode, set the arrangement's conducting state by turning on and off the first semiconductor switch while keeping the second semiconductor switch in the on-state. In this second operating mode the synchronous rectifier arrangement operates as a high-voltage normally-off FET switch.

The control circuit may further be arranged to, during a third operating mode, keep the second semiconductor switch in the off-state and apply no signal to the first control terminal of the first semiconductor switch. In this second operating mode the synchronous rectifier arrangement operates as a passive Schottky rectifier, but for voltages as high as those can the first semiconductor switch can block. Advantageously the first semiconductor switch switches its state automatically in this operating mode and thus requires no active control.

Embodiments of the present invention are now described with reference to the accompanying drawings to which the invention is not limited. The illustrations of the drawings are in schematic form. It is noted that in different figures, similar or identical elements use the same reference signs.
Fig. 1 illustrates a first high voltage cascode arrangement operating as a synchronous rectifier circuit using low voltage synchronous rectifier controller.
Fig. 2 illustrates a second high-voltage synchronous rectifier circuit with additional operation modes.

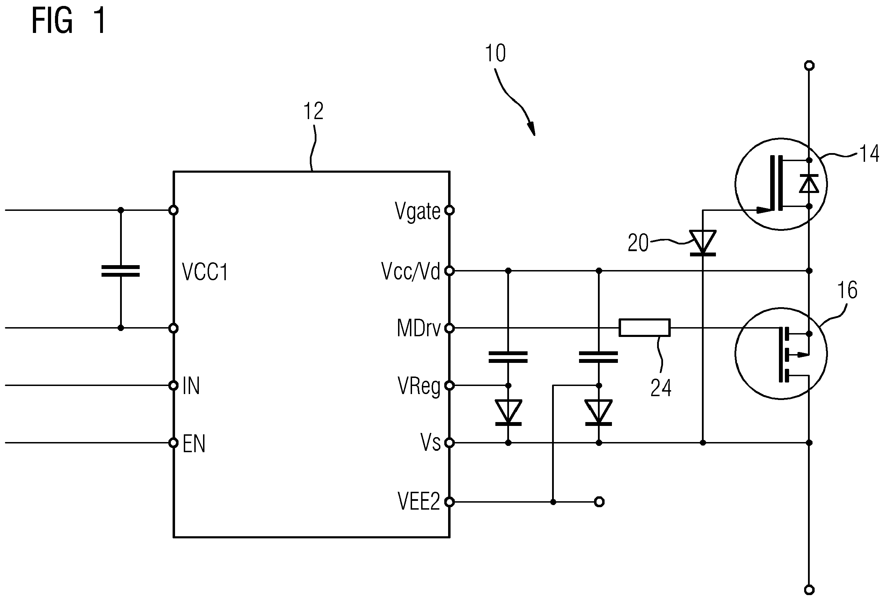

Figure 1 is a circuit diagram of a synchronous rectifier circuit 10 according to a first embodiment of the invention. Synchronous rectifier circuit 10 comprises a low-voltage synchronous rectifier gate drive unit 12. It further comprises a cascode circuit having a first semiconductor switch 14 and a second semiconductor switch 16.

The first semiconductor switch 14 is a depletion-type 650 V GaN (gallium nitride) field effect transistor (FET). In alternative embodiments the first semiconductor switch 14 can also be an SiC (silicon carbide) device. It has a first control terminal G14 and first source and drain terminals S14, D14 which are load terminals.

The second semiconductor switch 16 is an enhancement-type 30 V silicon MOSFET. It has a second control terminal G16 and second source and drain terminals S16, D16 which are load terminals.

In other words, the first semiconductor switch 14 is a high-voltage, ultra-fast switch while the second semiconductor switch 16 is a low-voltage switch.

The first source terminal S14 and the second drain terminal D16 are connected, so that the first and second semiconductor switch 14, 16 form a series connection.

The cascode circuit can be embodied as an integrated device comprising at least the first and second switch 14, 16. In this case the cascode circuit itself has a drain terminal formed by the first drain terminal D14, a source terminal formed by the second source terminal S16 and two control terminals formed by the first and second control terminals G14, G16.

The first drain terminal D14 forms a terminal of synchronous rectifier circuit 10 and may be connected to a voltage, for example an AC supply voltage. The second source terminal S16 forms another terminal of synchronous rectifier circuit 10 and may for example be connected to a load, in particular a circuit driven with a DC voltage.

Gate drive unit 12 is a unit that is specifically arranged to drive a synchronous rectifier circuit at low voltages of below 100 V, for example with a MOSFET semiconductor switch with a reverse voltage of 30 V such as the second semiconductor switch 16. It is, in other words a unit that is unsuitable for directly acting as a gate driver for a high voltage switch.

As further connections in the synchronous rectifier circuit 10, the first control terminal G14 is connected across a decoupling diode 20 to the second source terminal S16. Decoupling diode 20 is oriented to conduct from the first control terminal G14 to the second source terminal S16. The decoupling diode 20 which may be implemented by a single diode or a series of diodes should be arranged to be able to block the drain-source-voltage of the second semiconductor switch 16. The decoupling diode 20 allows controlling the gate of the first semiconductor switch 14.

A second control circuit control terminal MDrv is connected across a second resistor 24 to the second control terminal G16 of the second semiconductor switch 16. A first voltage sense input terminal Vd of the gate drive unit 12 is connected to the second drain terminal D16 and therefore also to the first source terminal S14 and one terminal of Schottky diode 18. A second voltage sense input terminal Vs of the gate drive unit 12 is connected to the second source terminal S16 and therefore also to the other terminal of Schottky diode 18 and one terminal of the decoupling diode 20.

Gate drive unit 12 is further connected to a supply voltage on its VCC terminals and to a higher-level controller (not shown in figure 1) such as a microcontroller circuit to receive control signals from this controller. The voltage sense input terminals Vd, Vs are additionally connected across two pairs of a capacitor and diode wherein each of the junctions between capacitor and diode is connected to a further terminal of gate driver unit 12.

The synchronous rectifier circuit 10 of figure 1 can operate as a synchronous rectifier. The gate driver unit 12 determines the voltage across the second semiconductor switch 16 on its voltage sense terminals Vd, Vs. When it detects that the voltage is negative, meaning Vs > Vd, the gate driver unit 12 switches on the second semiconductor switch 16 by applying a voltage to the second control terminal G16. Turning on the second semiconductor switch 16 short-circuits the source terminal S14 of the first semiconductor switch 14 to its control terminal G14, switching on the depletion mode first semiconductor switch 14.

If the voltage across the second semiconductor switch 16 is positive, the gate driver unit 12 switches off the second semiconductor switch 16 by removing the voltage to the second control terminal G16, making the voltage at its terminal MDrv equal to that of the second source terminal S16. Turning off the second semiconductor switch 16 short-circuits the source terminal S14 of the first semiconductor switch 14 to its control terminal G14, switching on the depletion mode first semiconductor switch 14. This increases the voltage at its drain terminal D16. When the pinch-off voltage of the first semiconductor switch is reached, it switches off and blocks the voltage across both switches 14, 16. It thereby also protects the second semiconductor switch 16 from voltages higher than its reverse voltage.

Notably this creates a synchronous rectifier able to operate with a high-voltage AC input. For example, the AC input voltage may have a peak of 400 V, 600 V, or even 1200 V. The synchronous rectifier circuit 10 is able to work with this voltage as long as the first semiconductor switch 14 is able to block this peak voltage. At the same time the synchronous rectifier circuit 10 uses a gate driver unit 12 that is configured to drive a synchronous rectifier but only suitable for controlling a low-voltage switch for synchronous rectifier operation.

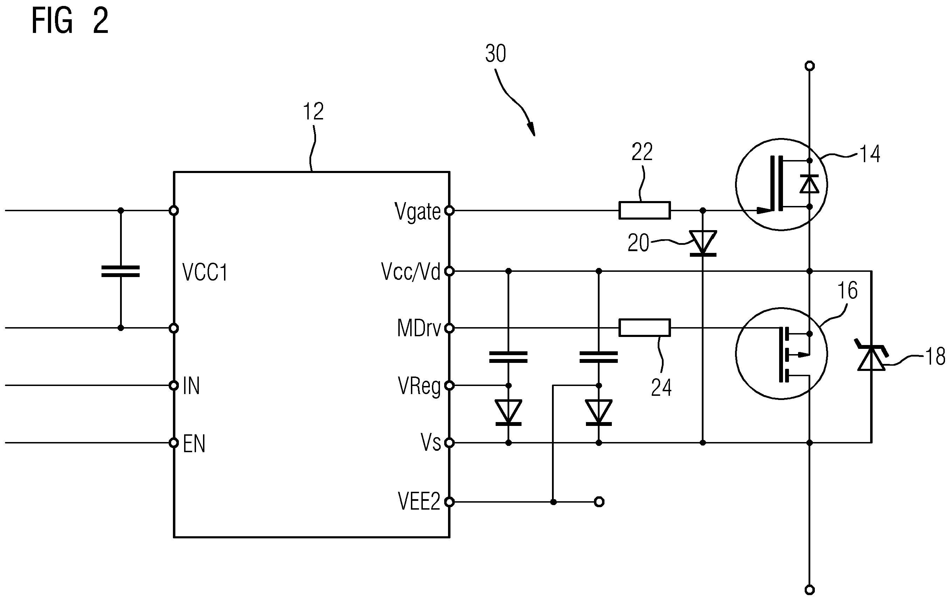

Figure 2 is a circuit diagram of a synchronous rectifier circuit 30 according to a second embodiment of the invention. Synchronous rectifier circuit 30 comprises the elements of synchronous rectifier circuit 10. In addition, a first control circuit control terminal Vgate is connected across a first resistor 22 to the first control terminal G14 of the first semiconductor switch 14.

Arranged in parallel to the second semiconductor switch 16 is a Schottky diode 18. Schottky diode 18 is oriented to block a forward polarity voltage across it and the second semiconductor switch.

Synchronous rectifier circuit 30 can be operated like the synchronous rectifier circuit 10 of the first embodiment of the invention, i.e. it can be operated as a synchronous (active) rectifier as a first mode of operation. Synchronous rectifier circuit 30 offers the option to use two additional operating modes.

In the second mode of operation, gate driver unit 12 controls the second semiconductor switch 16 to be continuously turned on by applying a voltage to the second control terminal 16, i.e. its gate terminal. At the same time the state of the first semiconductor switch 14 is controlled by the first control circuit control terminal Vgate. If at any point the second semiconductor switch 16 becomes turned off, either by a control signal of the gate driver unit 12 or through a malfunction within the synchronous rectifier circuit 30, the first semiconductor switch 14 will automatically be turned off regardless of any voltage applied at the first control circuit control terminal Vgate as explained above. Thus, in this mode of operation the synchronous rectifier circuit 30 acts as a high-voltage normally-off JFET switch.

In the third mode of operation, both semiconductor switches 14, 16 are continuously kept in a turned off state by not applying a turn-on voltage at their respective control terminals G14, G16.

In this mode of operation, when a negative voltage is applied across the switches, i.e., when the voltage at the second source terminal S16 is higher than that at the first drain terminal D14, Schottky diode 18 conducts and makes the voltage at the first source terminal S14 almost equal to that of the second source terminal S16 and thus the voltage at the first control terminal G14, disregarding the voltage drop of the decoupling diode 20, thus turning on the first semiconductor switch 14. This allows a current flow with the very low resistances intrinsic to both the Schottky diode 18 and the first semiconductor switch 14.

When the voltage across the switches 14, 16, i.e. the input AC voltage, becomes positive, Schottky diode 18 blocks the current, creating a voltage drop between the first source terminal S14 and the first control terminal G14, thus turning off the first semiconductor switch 14. The first semiconductor switch 14 then blocks the input voltage. As the first semiconductor switch 14 is a high-voltage device, it blocks the input voltage up to its reverse voltage, in this example 650 V. The Schottky diode 18 is thus protected from this input voltage which it could not block alone.

In this way, the Schottky diode 18 and the first semiconductor switch 14 together form a high-voltage Schottky diode equivalent. While a pure high-voltage Schottky diode device is not available, this combined circuit acts as such a device. The synchronous rectifier circuit 30 thus acts as a passive Schottky rectifier wherein no active control of gate terminals is necessary.

### List of reference numbers

- 10, 30: synchronous rectifier circuit
- 12: low voltage synchronous rectifier gate driver unit
- 14: first semiconductor switch
- D14: first drain terminal
- S14: first source terminal
- G14: first control terminal
- D16: second drain terminal
- S16: second source terminal
- G16: second control terminal
- 16: second semiconductor switch
- 18: Schottky diode
- 20: decoupling diode
- 22, 24: resistors

## Claims

1. Synchronous Rectifier arrangement (10, 30), comprising
- a first, depletion-mode, semiconductor switch (14) with first and second load terminals (S14, D14) and a first control terminal (G14),
- a second, enhancement mode, low-voltage semiconductor switch (16) with third and fourth load terminals (S16, D16) and a second control terminal (G16), the second and third load terminals (S14, D16) being electrically connected,
- a control circuit (12) connected to the second control terminal (G16) and arranged to turn the second semiconductor switch (16) on and off by applying a signal to the second control terminal (G16),
wherein
- the first semiconductor switch (14) has a higher maximum reverse voltage than the second semiconductor switch (16),
- the control circuit (12) is a low-voltage synchronous rectifier control circuit (12).

2. Synchronous Rectifier arrangement (10, 30) according to claim 1, wherein the reverse voltage of the first semiconductor switch (14) is at least 400 V, particularly at least 650 V, particularly at least 800 V.

3. Synchronous Rectifier arrangement (10, 30) according to claim 1 or 2, wherein the reverse voltage of the second semiconductor switch (16) is at most 100 V, particularly at most 50 V.

4. Synchronous Rectifier arrangement (10, 30) according to any of the preceding claims with a diode (18) arranged in parallel to the second semiconductor switch (16).

5. Synchronous Rectifier arrangement (10, 30) according to claim 4, wherein the diode (18) is a Schottky diode.

6. Synchronous Rectifier arrangement (10, 30) according to any of the preceding claims, wherein a first control circuit control terminal (Vgate) is connected across a first resistor (22) to the first control terminal (G14) of the first semiconductor switch (14).

7. Synchronous Rectifier arrangement (10, 30) according to any of the preceding claims, wherein a second control circuit control terminal (MDrv) is connected across a second resistor (24) to the second control terminal (G16) of the second semiconductor switch (16).

8. Synchronous Rectifier arrangement (10, 30) according to claim 7, wherein the control circuit (12) is arranged to, during a first operating mode, obtain a signal indicative of the voltage across the second semiconductor switch (16) and is further arranged to turn on the second semiconductor switch (16) when the signal indicates a reverse polarity voltage.

9. Synchronous Rectifier arrangement (10, 30) according to claims 6 and 7, wherein the control circuit (12) is arranged to, during a second operating mode, set the arrangement's conducting state by turning on and off the first semiconductor switch (14) while keeping the second semiconductor switch (16) in the on-state.

10. Synchronous Rectifier arrangement (10, 30) according to any of the preceding claims, wherein the control circuit (12) is arranged to, during a third operating mode, keep the second semiconductor switch (16) in the off-state and apply no signal to the first control terminal (G14) of the first semiconductor switch (14).
